(19) Europäisches Patentamt
European Patent Office
Office européen des brevets

(11) **EP 1 151 647 B1**

(12) **EUROPEAN PATENT SPECIFICATION**

(45) Date of publication and mention
of the grant of the patent:
**14.09.2005 Bulletin 2005/37**

(51) Int Cl.⁷: **H05K 5/00**, H05K 5/06,
H05K 7/20

(21) Application number: **99963823.2**

(22) Date of filing: **13.12.1999**

(86) International application number:
**PCT/SE1999/002324**

(87) International publication number:
**WO 2000/049842 (24.08.2000 Gazette 2000/34)**

(54) **ARRANGEMENT AT A PORTABLE ELECTRIC APPARATUS**

VORRICHTUNG IN EINEM TRAGBAREN ELEKTRISCHEN GERÄT

LOGEMENT POUR APPAREIL ELECTRIQUE PORTABLE

(84) Designated Contracting States:
**AT BE CH CY DE DK ES FI FR GB GR IE IT LI LU
MC NL PT SE**

(30) Priority: **18.02.1999 SE 9900566**

(43) Date of publication of application:
**07.11.2001 Bulletin 2001/45**

(73) Proprietor: **TELEFONAKTIEBOLAGET LM
ERICSSON (publ)
164 83 Stockholm (SE)**

(72) Inventor: **HOLMBERG, Per
S-240 10 Dalby (SE)**

(74) Representative: **Petri, Stellan et al
Ström & Gulliksson AB
P.O. Box 4188
203 13 Malmö (SE)**

(56) References cited:
**WO-A1-98/13273          FR-A1- 2 758 873
US-A- 5 583 742**

• **PATENT ABSTRACTS OF JAPAN & JP 10 126
713 A (SHOWA TEKKO KK) 15 May 1998**
• **PATENT ABSTRACTS OF JAPAN & JP 06 031
130 A (NEC CORP) 08 February 1994**

EP 1 151 647 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

## Description

## Technical Field of the invention.

The present invention relates to an arrangement at a portable electric apparatus comprising a main apparatus unit containing electronic equipment necessary therefore, and a detachable power source unit, the latter being disconnectably fixed to or in the apparatus unit, the arrangement being designed to allow ventilation of gaseous media in both directions inside and out from the apparatus unit as well as the power source unit to the atmosphere and vice versa due to changes in ambient temperature. More particularly, the present invention relates to a radio telephone having a removable rechargable battery pack

## Description of the Prior Art.

An arrangement in accordance with the preamble of claim 1 is disclosed in US-A-5 583 742.

Previously known solutions for similar purposes are like the one according to EP A1 0 831 572, mainly filter members for suppressing the likelyhood that particles and other unwanted material enter the interior of a device.

Electronic equipment, normally consuming electric energy, stored in some kind of battery attached to or housed in the equipment, is normally effected by said energy consumption since the temperature of the battery rises as its energy is consumed. If the battery is rechargeable, which often or normally is the case, also the recharging generates a substantial amount of heat as well as sometimes the emission of hydrogene gas. Variation in temperature normally gives rise to vapourization and condensation phenomena of moist existing almost everywhere, which in connection with mobile telephones until now has been tackled by natural leakage at joints and edges. This has also been the case with said possibly emitted hydrogene gas.

Electronic components of mobile telephones, like electronics overall, are normally not supposed to be exposed to moist, since this enhances the risk for short circuiting as well as the risk for the emergence of oxidation phenomena, which given time can destroy a component totally. Therefore natural leakage as mentioned above, for natural reasons may during unfortunate extreme circumstances give rise to uncontrollable short circuiting and/or oxidation phenomena in unspecific components. These phenomena may become especially frequent when using mobile telephones in extreme environments, such as in the tropics, where its user sometimes may stay indoors in air-conditioned circumstances at 20°C and a humidity of 60% and at other times is staying outdoors at temperatures of maybe up to 70°C and humidities of maybe 90 %.

During such extreme conditions the performance of almost any electronic devices or equipment may degenerate quickly, which of course never is or never has been the intention.

It is therefore an object with the present invention to develop an arrangement for positively ventilating surplus gas (mainly vapourized moist in air and hydrogene gas) contained and generated inside a mobile telephone interior to the exterior thereof as well as providing means for submitting gas (air and no moist) to the interior thereof in a controlled fashion, avoiding as far as possible exposing sensitive electronic equipment to moist normally contained everywhere in the atmosphere.

Another object with the present invention is to attain a mobile telephone, which as far as possible is water protected, ie can withstand water as due to an accidental exposure thereof to said media. Such apparatus is however not intended to be water proof in its widest meaning.

Another object is to attain a mobile telephone, which by the arrangement of channels for achieving a positive ventilation, also gains the effect of creating a pressure equalizer, which is a component that equalizes the possible internal positive or negative pressure that may result from a waterprotection design necessary for attaing the above object.

In water protected electronic equipment the problem regarding moist whether condensated or vapourized and/or hydrogene gas becomes worse, in the absence of some kind of ventilation arrangement. The moist will consequently become enclosed with known consequences. The possible hydrogene gas will become more and more concentrated and may when released, for instance when charging a battery, oxidize into oxyhydrogene gas, which after ignitition by for instance a spark when releasing the battery, will react according to the formula:

$$H_2(g) + \tfrac{1}{2}\, O_2(g) \rightarrow H_2O\ (1)\ ; \Delta H° = -260kJ,$$

a reaction which is more or less like an explosion.

## Summary of the Invention.

According to the invention as claimed, means are provided for freely/positively admitting gaseous media (mainly air and hydrogene gas) in a controlled fashion via orifices and as least one channel in discrete components, such as the battery and/or compartments of said apparatus via said means.

According to a further developed embodiment of the invention said means physically is a channel or integrated channels encompassing said orifices in order to equally equalize air pressure in each and all of said components or compartments. Hereby the ventilation of said presumably vapourized moist containing air and hydrogene gas is performed in a more controlled fashion so that said media will evaporate from their origin as soon as possible without affecting surrounding equipment.

In a yet further developed embodiment said discrete channels are at their ends collected to a mutual outlet channel to the outside of the telephone.

This outlet channel is according to a further developed embodiment at its outer end equipped with filter media, preferably made from a material having a "breathing" ability/function, like for instance GORE-TEX®.

In a further class of embodiments said channels are systematically arranged in for instance a honeycomb structure, regularly or irregularly spirally wound in one or more layers. This gives an opportunity to more specifically catch vapourized moist or other gas at the spot where they are the most concentrated.

Channels of the above described kind will during certain conditions also structurally strengthen a housing/shell for such a mobile telephone, in that the channels are arranged in connection with such a shell and thereby affects the moment of inertia thereof.

The most promising advantage with the invention lies in the combination of a water protected telephone that without developing above- or sub-athmospheric pressure on the inside of the telephone automatically can submit the substances in question to the atmosphere.

**Brief Description of the Drawings.**

Below the invention is described more in detail with reference to the enclosed drawings, in which:

Fig 1 shows a simplified perspective view of a mobile telephone comprising an arrangement according to the invention;

Fig 2 shows a cross section from II-II in Fig 1,

Fig 3 shows a less simplified perspective view of a mobile telephone, the housing of which here shows the cavities for a keypad, and on which a partially cut away portion shows an arrangement according to the invention;

Fig 4, analogous with fig 3, shows an alternate embodiment of a channel configuration according to the invention, and

Fig 5 shows a perspective view of a cutaway portion of a channel which comprise a honeycomb structure according to the invention.

**Detailed Description of the Invention.**

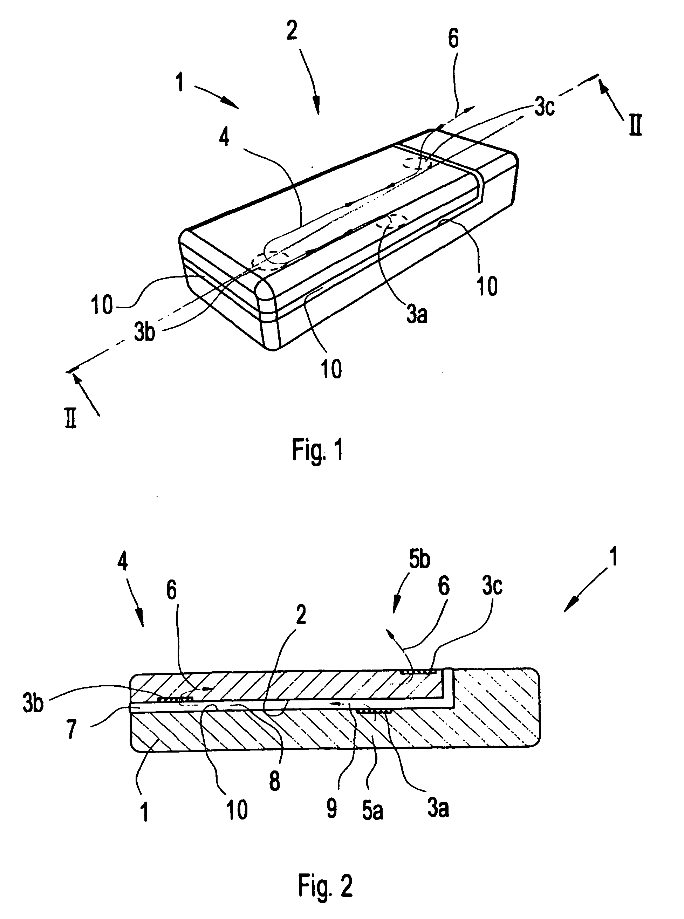

In a simplified embodiment of a mobile telephone, which in Fig 1 and 2 is shown for illustrative purposes only, the inventive embodiment comprises a housing 1 and a removably fixed battery 2 as well as three vents 3a, 3b, 3c. One of these vents 3a is arranged on an upper portion 5a of the housing 1 of the mobile telephone, whilst the other two vents 3b and 3c are arranged on the battery 2, the vent 3b on the rear side lower portion 4 of the battery 2 and the vent 3c on the outside upper portion 5 of the battery 2.

With a tiny sketched line 6 provided with arrows the transport through the vents is shown in both Fig 1 and Fig 2. By arranging the holes 3a and 3b at such a relatively long distance from each other, the air heated by the battery can attract moist and vapourize it over a long distance in the space from at around 7 and 8 and further at around 9 in the space between the housing 1 and the battery 2. A sealing 10 is arranged along the edge of the battery 2 and the housing 1, to attain the aforesaid water protection. The holes 3a - 3c, are each covered by a polymer membrane of a "breathable material" such as GORE-TEX®. Since such a material only allows the penatration of gas and vapourized moist the telephone will become water-protected in spite of being ventilated.

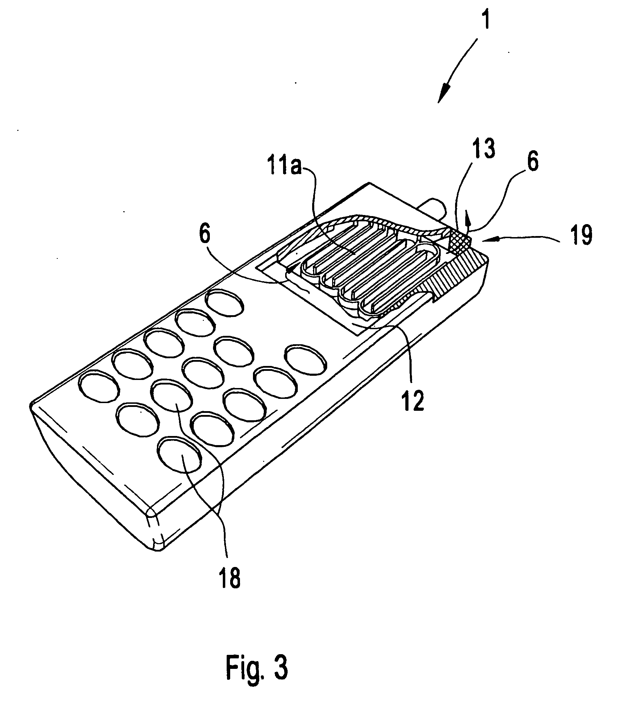

Fig 3 shows a preferred arrangement on a mobile telephone according to the invention, according to which a continuous channel 11a, like a maze, is arranged behind the area where normally a display 12 of telephone is situated. Fig. 3 also includes key-pad cavities 18, the purpose of which is well known to the skilled man. The primary purpose of this design is to achieve a channel having an extended length and the purpose of which is to constitute a pressure equalizer between the atmospheric pressure and the pressure inside the telephone. Because of the length of the channel vapourized moist in air sucked into the phone due to a sudden lowered temperature will condensate on the walls of the lengthy channel, thus no moist will preferably reach the components of the telephone. The extension of the channel according to this embodiment, at the rear side of the display of the telephone, makes ventilation of said display as well reasonably easy. In such a case the rear side of the display may be penetrated at chosen spots. These spots are in turn provided with a breathable membrane according to the above allowing potential moist inside the display unit to evaporate.

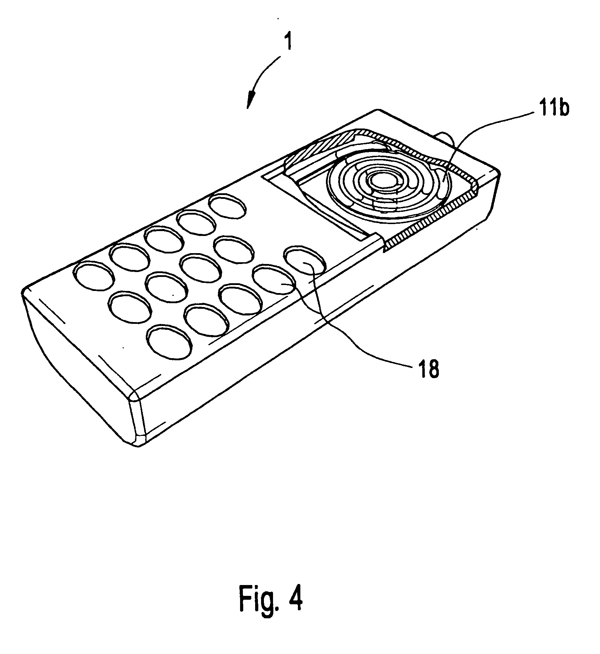

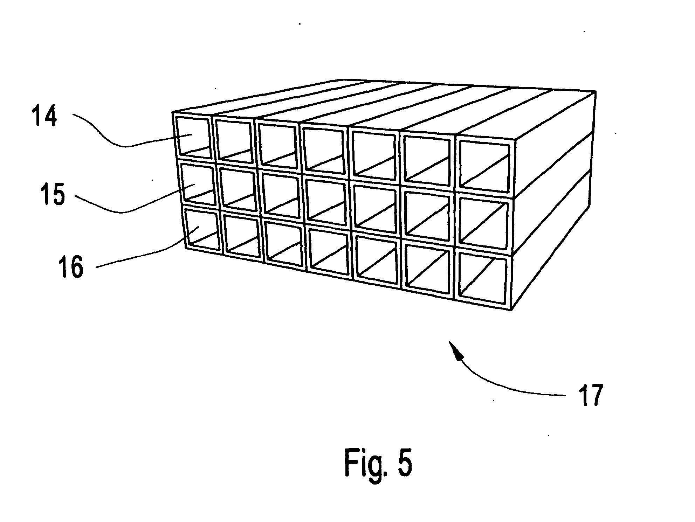

According to Fig 4 another inventive embodiment is shown having a spirally wound channel 11b. If suitable said channels 11a Fig. 3 and 11b may be differently shaped dependent upon their purpose. Apart from that the channels may be differently shaped, they may also be arranged in several layers 14, 15, 16 each as shown in Fig 5, constituting a honeycomb structure 17. When so arranged the channels may become longer, which means that a larger amount of vaporised moist may condensate on the walls thereof. As shown in the respective Figs, the channel/channels always have at least one opening to the interior of the telephone as well as at least one opening to its exterior (having a breathable membrane). It is of course possible to imagine even a further development of the channel system of a telephone, like for instance giving the channels different cross-section in different parts thereof. This would enhance the possibilities of forced condensation due to laws of Physics, ie. at a constriction speed of the media becomes higher which promotes condensation.

Combinations of the differently shaped channels and sub-features thereof, are of course possible and also considered protected under the appended claims.

## Claims

1. Arrangement at a portable electric apparatus comprising a main apparatus unit (1), for example a housing (1) of a mobile telephone, containing electronic equipment necessary therefore, and a detachable power source unit (2), the latter being disconnectably fixed to or in the apparatus unit (1), the arrangement being designed to allow ventilation of gaseous media in both directions inside and out from the apparatus unit (1) as well as from the power source unit (2) to the atmosphere and vice versa due to changes in ambient temperature, **characterized in that** at least one channel (11a, 11b) is provided for admitting said gaseous media, mainly air and hydrogen gas, to flow in a controlled fashion via at least one vent orifice (3a, 3b, 3c) in the discrete components (1, 2), such as the power source unit (2) or compartments of said main apparatus unit (1) and via said channel (11a, 11b), and **in that** said channel (11a, 11b) is arranged both in connection with said discrete components and in connection with compartments of the apparatus, for structurally shengthening said apparatus.

2. Arrangement according to claim 1, **characterized in that** said channel (11a, 11b) is integrated with said orifice (3a, 3b, 3c) and extends through said discrete components (1, 2) or compartments in order to equally equalize air pressure in each and all of said components or compartments.

3. Arrangement according to claim 1 or 2, **characterized in that** the end of the channel (11a, 11b) is sealed with a filter media to avoid unwanted material entering the telephone interior.

4. Arrangement according to claim 3, **characterized in that** said filter media comprise material (13) having a breathing function, admitting vaporized moist and air in a forward direction towards the exterior, however not admitting moist in a rearward direction toward the interior of the telephone.

5. Arrangement according to anyone of the preceding claims, **characterized in that** it is deviced on a mobile telephone of water protected construction.

6. Arrangement according to anyone of the preceding claims, **characterized in that** the channels are arranged like a honeycomb structure (17) connected to said housing.

7. Arrangement according to anyone of the preceding claims, **characterized in that** said at least one channel (11a, 11b) is spirally wound along and connected to at least part of said housing.

8. Arrangement according to anyone of the preceding claims, **characterized in that** at least one channel is of a cross-section that varies.

## Patentansprüche

1. Einrichtung bei einem tragbaren elektrischen Gerät, das eine Hauptgeräteeinheit (1) aufweist, beispielsweise ein Gehäuse (1) eines Mobiltelefons, welche eine hierfür erforderliche elektrische Betriebseinrichtung enthält, und eine abnehmbare Stromversorgungseinheit (2), welche abnehmbar an oder in der Geräteeinheit (1) befestigt ist, wobei die Einrichtung so ausgelegt ist, dass sie eine Belüftung gasförmiger Medien in beiden Richtungen innerhalb und außerhalb von der Geräteinheit (1) ermöglicht, sowie von Stromversorgungsquelleneinheit (2) zur Atmosphäre und umgekehrt, infolge von Änderungen der Umgebungstemperatur, **dadurch gekennzeichnet, dass** zumindest ein Kanal (11a, 11b) zum Zuführen der gasförmigen Medien, hauptsächlich Luft- und Wasserstoffgas, so vorgesehen ist, dass diese auf kontrollierte Art und Weise über zumindest eine Belüftungsöffnung (3a, 3b, 3c) in den diskreten Bauteilen (1, 2) fließen, beispielsweise der Stromversorgungsquelleneinheit (2) oder Abteilen der Hauptgeräteeinheit (1) und über den Kanal (11a, 11b), und dass der Kanal (11a, 11b) sowohl in Verbindung mit den diskreten Bauteilen als auch in Verbindung mit Abteilen des Geräts angeordnet ist, um baulich das Gerät zu verstärken.

2. Einrichtung nach Anspruch 1, **dadurch gekennzeichnet, dass** der Kanal (11a, 11b) mit der Öffnung (3a, 3b, 3c) vereinigt ist und sich durch die diskreten Bauteile (1, 2) oder Abteile erstreckt, um den Luftdruck in jedem und sämtlichen der Bauteile oder Abteile anzugleichen.

3. Einrichtung nach Anspruch 1 oder 2, **dadurch gekennzeichnet, dass** das Ende des Kanals (11a, 11b) durch ein Filtermedium abgedichtet ist, um zu verhindern, dass unerwünschtes Material in das Telefoninnere eindringt.

4. Einrichtung nach Anspruch 3, **dadurch gekennzeichnet, dass** die Filtermedien Material (13) aufweisen, welches atmungsfähig ist, und verdampfte Feuchte und Luft in Vorwärtsrichtung nach außen hin zutreten lässt, jedoch nicht Feuchte in Rückwärtsrichtung zum Inneren des Telefons zutreten lässt.

5. Einrichtung nach einem der voranstehenden Ansprüche, **dadurch gekennzeichnet, dass** sie bei einem Mobiltelefon mit wassergeschützter Konstruktion vorgesehen ist.

6. Einrichtung nach einem der voranstehenden Ansprüche, **dadurch gekennzeichnet, dass** die Kanäle wie eine Bienenwabenanordnung (17) angeordnet sind, die mit dem Gehäuse verbunden ist.

7. Einrichtung nach einem der voranstehenden Ansprüche, **dadurch gekennzeichnet, dass** der zumindest eine Kanal (11a, 11b) spiralförmig entlang zumindest einem Teil des Gehäuses gewunden und mit diesem Teil verbunden ist.

8. Einrichtung nach einem der voranstehenden Ansprüche, **dadurch gekennzeichnet, dass** der zumindest eine Kanal einen Querschnitt aufweist, der sich ändert.

**Revendications**

1. Agencement d'un appareil électrique portable comprenant une unité d'appareil principale (1), par exemple un boîtier (1) d'un téléphone mobile, contenant l'équipement électronique nécessaire pour ledit appareil, et une unité de source d'alimentation détachable (2), cette dernière étant fixée de façon à pouvoir être déconnectée à ou dans l'unité d'appareil (1), l'agencement étant conçu de manière à permettre la ventilation d'un milieu gazeux dans les deux directions à l'intérieur et à l'extérieur de l'unité d'appareil (1) ainsi qu'à partir de l'unité de source de courant (2) vers l'atmosphère et vice versa à la suite d'une variation de la température ambiante, **caractérisé en ce qu'**au moins un canal (11a, 11b) est prévu pour laisser entrer ledit milieu gazeux, principalement de l'air et de l'hydrogène gazeux, afin qu'il s'écoule d'une façon régulée via au moins un orifice d'aération (3a, 3b, 3c) dans les composants individuels (1, 2), tels que l'unité de source de courant (2) ou les compartiments de ladite unité d'appareil principale (1), et via ledit canal (11a, 11b), et **en ce que** ledit canal (11a, 11b) est agencé à la fois en connexion avec lesdits composants individuels et en connexion avec les compartiments de l'appareil afin de renforcer la structure de l'appareil.

2. Agencement selon la revendication 1, **caractérisé en ce que** ledit canal (11a, 11b) est d'un seul tenant avec ledit orifice (3a, 3b, 3c) et s'étend à travers lesdits composants individuels (1, 2) ou lesdits compartiments en vue d'égaliser la pression d'air dans chacun desdits composants ou compartiments.

3. Agencement selon la revendication 1 ou 2, **caractérisé en ce que** l'extrémité du canal (11a, 11b) est isolée avec un moyen de filtre destiné à empêcher toute matière indésirable de pénétrer à l'intérieur du téléphone.

4. Agencement selon la revendication 3, **caractérisé en ce que** ledit moyen de filtre comprend une matière (13) présentant une fonction de respiration laissant passer l'humidité et l'air vaporisés dans une direction avant vers l'extérieur, mais ne laissant pas passer l'humidité dans une direction arrière vers l'intérieur du téléphone.

5. Agencement selon l'une quelconque des revendications précédentes, **caractérisé en ce qu'**il est installé sur un téléphone mobile conçu pour être étanche à l'eau.

6. Agencement selon l'une quelconque des revendications précédentes, **caractérisé en ce que** les canaux sont agencés sous la forme d'une structure en nid d'abeilles (17) reliée audit boîtier.

7. Agencement selon l'une quelconque des revendications précédentes, **caractérisé en ce que** ledit au moins un canal (11a, 11b) est enroulé en spirale le long d'au moins une partie dudit boîtier et connecté à celle-ci.

8. Agencement selon l'une quelconque des revendications précédentes, **caractérisé en ce qu'**au moins un canal présente une section transversale variable.

Fig. 1

Fig. 2

Fig. 3

Fig. 4

Fig. 5